Europäisches Patentamt

(19) European Patent Office

Office européen des brevets

(11) Numéro de publication: 0 004 555
A2

(12) # DEMANDE DE BREVET EUROPEEN

(21) Numéro de dépôt: 79100621.6

(22) Date de dépôt: 02.03.79

(51) Int. Cl.²: **G 03 C 1/72**
**G 03 F 7/10, C 08 L 33/10**

(30) Priorité: 03.04.78 US 893093

(43) Date de publication de la demande:
17.10.79 Bulletin 79/21

(84) Etats Contractants Désignés:
DE FR GB

(71) Demandeur: International Business Machines
Corporation

Armonk, N.Y. 10504(US)

(72) Inventeur: Hatzakis, Michael
21 Collyer Drive
Ossining New York 10562(US)

(72) Inventeur: Webb, David John
7 Parkway Road
Briarcliff Manor New York 10510(US)

(74) Mandataire: Klein, Daniel
COMPAGNIE IBM FRANCE Département de Propriété
Industrielle
F-06610 La Gaude(FR)

(54) **Résine sensible aux électrons comportant un sel métallique d'un méthacrylate et application à la lithographie à faisceau d'électrons.**

(57) La présente invention concerne une résine sensible aux électrons, constituée par un polymère non réticulé qui comporte:

a) des unités polymérisées de méthacrylate d'alkyle dans lesquelles le groupe alkyle contient de 1 à 4 atomes de carbone et

b) des unités polymérisées d'un sel de l'acide méthacrylique et d'un métal, ce dernier étant choisi dans le groupe composé du baryum, du calcium, du strontium, et du plomb,

la quantité des unités de type a) est comprise entre 50% et 99,99% en mole et la quantité des unités de type b) est comprise entre 50% et 0,01% en mole du nombre total de mole, tandis que le métal constitue de 0,001% à 10% en poids du polymère. Le métal préféré est le plomb.

Cette résine trouve application dans les étapes lithographiques de la fabrication des circuits intégrés à semi-conducteurs, car elle présente en particulier un rapport de solubilité S/So (entre les parties exposées et non exposées) plus élevé que les résines classiques de type polyméthacrylate de méthyle (PMMA), pour une exposition donnée.

FIG. 4

1

RESINE SENSIBLE AUX ELECTRONS COMPORTANT
UN SEL METALLIQUE D'UN METHACRYLATE ET APPLICATION
A LA LITHOGRAPHIE A FAISCEAU D'ELECTRONS

Description

Domaine Technique

La présente invention concerne une résine sensible aux électrons et son application aux étapes de lithographie par faisceau d'électrons.

Etat de la technique

La fabrication de micro-circuits exige la réalisation de configurations permettant de définir les différents éléments des circuits. On utilise à cette fin des matériaux polymériques qui sont sensibles à divers types de radiation, par exemple une radiation électronique, la lumière ultraviolette ou les rayons x. L'emploi de méthacrylate d'alkyle comme polymère susceptible de se dégrader lors d'une exposition à un faisceau électronique, pour former des masques en résine photosensible utilisables aux fins de la fabrication de circuits intégrés, de plaques d'impression, etc., a déjà été proposé. Par exemple, le brevet des E.U.A. No. 3 535 137 préconise notamment l'emploi de polymères de

2

méthacrylate contenant une structure en polymère de carbone quaternaire tel que du poly-méthacrylate de méthyle et des copolymères de méthacrylate avec du méthacrylate 2-hydroxy-éthyle à cette fin. D'autre part, le brevet des E.U.A. No. 3 779 806 préconise l'utilisation de certains polymères de P-butylmétha-crylate. A cet égard, on se reportera utilement à l'article de R.A. Harris intitulé "Polymethylmetha-crylate as Electron Sensitive Resist", paru dans la publication intitulée "J. Electrical Chemical Society", Vol. 120, No.2, pages 270 à 274, février 1973, et à l'article de E.D. Roberts intitulé "Modified Metha-crylate Positive Electron Resist", paru dans "Applied Polymers Symposium", No.23, pages 87 à 98, 1974. Enfin, l'article de R. Feder et al. intitulé "Heavy Metal Salts of Acidic Copolymers for Use as Radiation Sensitive Resist", paru dans la publication "IBM Technical Disclo-sure Bulletin", Vol. 18, No.7, décembre 1975, page 2343, décrit un copolymère de méthacrylate de méthyle et de l'acide méthacrylique comportant des sels de métaux lourds tels que le césium et le thallium.

Exposé de la présente invention

Pour les besoins de la fabrication de micro-circuits au moyen de la lithographie à faisceau électronique, il est souhaitable qu'une résine photosensible positive possède plusieurs des propriétés suivantes. Par exemple, elle doit être très sensible aux radiations employées aux fins de l'exposition, afin que la durée de chaque exposition soit courte et que l'on puisse de ce fait obtenir une cadence de production élevée. Un contraste important entre les régions exposées et non exposées est nécessaire pour permettre de commander de façon satisfaisante la géométrie des configurations. Une bonne stabilité mécanique aux températures élevées est également nécessaire, pour préserver les configurations lors d'opérations ultérieures de fabrication faisant appel à l'emploi de telles températures. Une résistance satisfaisante aux produits chimiques utilisés lors d'opérations de décapage et de plaquage est également indispensable. Il est en outre important que, lors du développement et du retrait de la résine photosensible, cette dernière ne laisse aucun résidu sur le substrat qui pourrait nuire aux opérations effectuées ultérieurement (contamination). Il est également souhaitable que des films épais soient employés. Cela est particulièrement important au cours d'opérations de métallisation additives, par exemple, par la technique dite de décollement(lift-off). L'épaisseur de la résine photosensible est souvent limitée par le fait que des fendillements se produisent en cours de développement.

L'objet de la présente invention est donc de fournir un matériau répondant à tous les desiderata mentionnés ci-dessus.

La présente invention concerne une résine de type positif, sensible aux électrons, constituée par un polymère non réticulé, essentiellement caractérisé en ce qu'elle comporte:

a) des unités polymérisées de méthacrylate d'alkyle dans lesquelles le groupe alkyle contient de 1 à 4 atomes de carbone, et

b) des unités polymérisées d'un sel de l'acide méthacrylique et d'un métal, le métal étant

4

choisi dans le groupe constitué par le plomb, le baryum, le calcium et le strontium;

la quantité d'unités de type (a) est comprise entre 50 et 99,99% en mole, celle d'unités de type (b) est comprise entre 50 et 0,01% en mole, en fonction du nombre total de moles de type (a) et de type (b) que comporte le polymère;

ledit métal présent est compris entre 0,001 et 10% en poids du polymère. Les gammes préférées pour chaque métal sont les suivantes: le plomb de 1% à 4% environ, le calcium de 0,02 à 0,035% environ, le baryum de 0,05 à 0,4% environ, et le strontium de 0,003 à 0,02% environ.

La présente invention concerne également son procédé de fabrication et un exemple d'application de cette résine à la lithographie par faisceau d'électrons.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 est un graphique représentant le rapport de solubilité des copolymères de méthacrylate de plomb.

La figure 2 est un graphique représentant le rapport de solubilité des copolymères de méthacrylate de baryum.

5

La figure 3 est un graphique représentant le rapport de solubilité des copolymères de méthacrylate de strontium et de méthacrylate de calcium.

La figure 4 est un graphique représentant le rapport de solubilité du méthacrylate de méthyle et de son copolymère avec un sel métallique de l'acide méthacrylique.

### Description détaillée des modes de réalisation préférés

Un matériau qui peut être employé conformément à la présente invention est un polymère non réticulé qui contient des unités (type a) polymérisées de méthacrylate d'alkyle où le groupe alkyle contient de 1 à 4 atomes de carbone; et des unités polymérisées (type b) d'un sel de l'acide méthacrylique et d'un métal choisi dans le groupe constitué par le plomb, le baryum, le calcium et le strontium.

Des unités de méthacrylate d'alkyle qui conviennent sont, par exemple, le méthacrylate de méthyle et le méthacrylate de t-butyle. Le méthacrylate de méthyle est le matériau préféré. Des mélanges de méthacrylate d'alkyle peuvent éventuellement être employés. Les unités de type b sont choisies parmi les sels de Pb, de Ba, de Ca ou de Sr, de l'acide méthacrylique. Le sel de Pb est préféré. Des mélanges de ces unités peuvent également être utilisés.

Les polymères ci-dessus peuvent être des copolymères à structure aléatoire, des copolymères branchés, des copolymères avec une structure bloc, ou des mélanges compatibles (c'est-à-dire homogènes) d'homopolymères ou des mélanges des matériaux précédemment indiqués

6

lorsqu'ils sont compatibles. En général, la quantité relative d'unités polymérisées de méthacrylate d'alkyle dans le polymère ci-dessus, est comprise entre 99,99% et 50% environ en mole et la quantité relative des unités polymérisées de l'autre type est comprise entre 0,01% et 50% environ en mole, sur la base du nombre total de moles.

Le polymère contient de préférence de 99,99% à 60% environ en mole d'unités polymérisées de méthacrylate d'alkyle, et si possible de 99,5% à 80% environ en mole sur la base du nombre total de moles.

Le polymère doit contenir des unités polymérisées de type b dont le nombre est compris entre 0,01% et 40% en mole, et de préférence entre 0,5% et 20% environ en mole, sur la base du nombre total de moles, que comporte le polymère. Cependant, il convient de préciser que ce dernier peut éventuellement contenir de faibles quantités (c'est-à-dire ne dépassant pas 30% en mole environ) d'unités polymérisées de type b autres que celles précédemment mentionnées (c'est-à-dire de l'acide méthacrylique, de l'acide acrylique et de l'acide crotonique) tant que cela ne nuit pas à la sensibilité du polymère au faisceau électronique ou ne se traduit pas par la formation de résidus insolubles dans le polymère exposé, par exemple par réticulation, et enfin tant que la quantité totale des unités de type b autres que les unités de méthacrylate d'alkyle ne dépasse pas 50% environ en mole, du polymère.

En général, les polymères employés conformément à la présente invention ont une masse moléculaire en nombre ($\overline{Mn}$) comprise entre $1 \times 10^4$ et $10^6$ environ, et de

7

préférence entre $10^5$ et 3 x $10^5$ environ, et une masse moléculaire en poids ($\overline{M\omega}$) comprise entre 2 x $10^4$ et 2 x $10^6$ environ et de préférence entre 2 x $10^5$ et 6 x $10^5$ environ. Le polymère a un indice de dispersion préféré ($\overline{M\omega}/\overline{Mn}$) (une mesure de la largeur de distribution) inférieur à 2.

Un procédé de préparation de polymères qui est employé dans la présente invention est un procédé de polymérisation par solution faisant appel à l'emploi d'un initiateur à radicaux libres. Des diluants utilisables aux fins de solution de polymérisation sont, par exemple, l'acide acétique glacial, d'autres acides organiques saturés liquides à température ambiante, par exemple l'acide formique, ou des mélanges de ces produits avec de l'eau ou d'autres solvants organiques, par exemple des alcools ou des mélanges d'alcools et d'eau.

Des catalyseurs ou des initiateurs à radicaux libres qui présentent un intérêt particulier comprennent les catalyseurs du type azo tels que les catalyseurs azo-bisisobutyronitrile et péroxyde. Quelques exemples de catalyseurs à base de péroxyde comprennent le péroxyde d'hydrogène, le péroxyde de benzoyle, le péroxyde ter-butyle, le péroxyde phthalique, le péroxyde succinique, le péroxyde de benzoyle acétique, le péroxyde d'huile de coco acide, le péroxyde laurique, le péroxyde stéarique, le péroxyde oléique, le ter-butyl-diperphthalate, l'hydropéroxyde de cumène, le tert-butylperbenzoate, le péroxyde acétyle, le péroxyde 2,4 dichlorobenzole, le péroxyde d'urée, le péroxyde caprylique, et autres produits analogues.

8

La quantité de diluant utilisée est fonction du diluant et des monomères particuliers employés et est généralement comprise entre 0,1 part et 30 parts environ, et de préférence entre 0,2 et 10 parts environ par part de monomère polymérisable.

La quantité de catalyseur utilisée est fonction du type de système de catalyseur employé et varie généralement entre 0,1 et 2,5 parts en poids par 100 parts de monomère polymérisable, et de préférence entre 0,2 et 1 part environ en poids pour 100 parts de monomère polymérisable.

La polymérisation s'effectue généralement à des températures comprises entre la température ambiante et 150°C environ, et de préférence entre 50°C et 100°C environ. En général, elle est effectuée sous pression autogène dans un récipient de réaction fermé. Cependant, tout autre moyen permettant d'éviter une évaporation importante des monomères peut être employé.

L'oxygène dissout peut éventuellement être retiré par des moyens appropriés, par exemple par des cycles de congélation, de pompage et de dégel, et les inhibants peuvent être retirés des monomères par des procédés appropriés, par exemple par lavage, distillation, chromatographie, etc. .

En général, la polymérisation est terminée dans un intervalle de temps variant entre 15 minutes et 36 heures environ, et généralement entre 30 minutes et 24 heures. La durée de l'opération est évidemment inversement proportionnelle à la température employée: si cette dernière est proche de la limite supérieure de la

9

plage indiquée, la polymérisation sera achevée dans un intervalle de temps proche de la limite inférieure de la plage des durées indiquées.

Les polymères utilisés dans le cadre de la présente invention sont normalement déposés sur un substrat à partir d'une solution du polymère par centrifugation, immersion, ou par toute autre technique convenable, puis séchés de manière à retirer la matière volatile. La solution du polymère doit être compatible avec le substrat. Les solvants utilisés doivent avoir un point d'ébullition inférieur au point de décomposition du polymère employé afin de permettre le retrait du solvant du film ainsi déposé par chauffage. Par exemple, on peut utiliser comme solvants l'acétate d'éther éthylglycolique, le chlorobenzène, les acides carboxyliques saturés liquides, les hydrocarbones halogénés, par exemple le chlorobenzène, les cétones, par exemple le méthyléthylcétone, les éthers éthylglycoliques, le diméthylformamide, le diméthylsulfoxyde, le tétrahydrofuranne.

La détermination d'un système de solvant spécifique pour un polymère déterminé dépend essentiellement de l'identité chimique du polymère et de la masse moléculaire, et ne présente pas de difficultés particulières.

L'épaisseur des films polymères déposés peut varier entre 1000 Å et 2 microns environ. L'épaisseur particulière choisie dépend du type de traitement utilisé. Par exemple, une épaisseur comprise entre 0,5 et 2 microns est généralement souhaitable dans le cas d'un décapage, alors qu'une épaisseur comprise entre 1 et 3 microns environ est au principe employée aux fins d'un traitement métallurgique associé à un décollement (lift-off).

De plus, il est préférable de procéder à une pré-cuisson du film de résine polymère dans de l'air ou dans le vide à une température généralement supérieure à la température de passage à l'état vitreux de la résine, mais inférieure à sa température de décomposition thermique. Cette pré-cuisson a pour but de retirer les traces du solvant utilisé lors de l'étape de revêtement, et de supprimer par recuisson les tensions présentes dans le polymère. A titre d'exemple, les températures de pré-cuisson sont comprises entre 70° et 250°C environ dans le cas de copolymères de méthacrylate de méthyle et de méthacrylates métalliques, les températures préférées étant comprises entre 140° et 200°C environ.

Divers substrats peuvent être utilisés comme supports pour la résine sensible de la présente invention. Par exemple, lorsque cette résine est utilisée aux fins de la fabrication de dispositifs semi-conducteurs ou de circuits intégrés, le substrat peut être constitué par des surfaces semi-conductrices recouvertes d'oxyde et de nitrure, par exemple d'oxyde de silicium et de nitrure de silicium, aux fins des étapes de masquage et de passivation, permettant notamment de former des contacts et des configurations de conducteurs sur ces surfaces.

Après séchage du film, celui-ci est exposé à un faisceau électronique définissant la configuration requise aux fins de la réalisation, par exemple, de circuits intégrés. La sensibilité accrue des polymères de la présente invention associée à l'emploi de produits de développement

11

appropriés, permet l'emploi d'une radiation électronique à faible dose. Le flux d'exposition spécifique dépend normalement du polymère particulier que l'on utilise et de l'épaisseur de la couche de résine sensible. En général, pour exposer un film de polymère dont l'épaisseur est comprise entre 1000 $\overset{\circ}{A}$ environ et 10 microns environ, on utilise un faisceau électronique de $10^{-6}$ à $10^{-3}$ coulombs/cm$^2$ environ et de préférence de $10^{-5}$ à $10^{-4}$ coulombs/cm$^2$ environ, et à un potentiel d'accélération compris entre 1 kv et une valeur supérieure à 50 kv, et de préférence compris entre 10 et 30 kv environ. L'exposition assure la copolymérisation des polymères utilisés.

Les parties exposées du film polymère (en fait les produits dégradés de masse moléculaire inférieur) sont ensuite retirées au moyen d'un solvant approprié présentant une solubilité nettement moindre pour les régions non exposées de la résine. La présente invention provoque une dégradation par exposition de la chaîne polymère supérieure à celle qui était obtenue dans le cas des homopolymères de polyméthacrylate de méthyle et autres matériaux analogues.

Les parties exposées sont généralement retirées au moyen du solvant à des températures comprises entre 10° et 100°C environ. La durée du développement est généralement comprise entre 1 et 60 minutes environ, et de préférence entre 5 et 15 minutes environ. La durée du développement peut évidemment être modifiée par des facteurs tels que la nature du polymère particulier que l'on utilise, l'épaisseur du film, le système de solvant particulier employé, la température particulière à laquelle s'effectue l'étape de développement et la dose

12

d'exposition.

Divers types de système de solvant ou de procédés de développement peuvent être employés. Par exemple, on peut utiliser un système de solvant qui convient à la fois aux polymères exposés et non exposés lorsqu'un processus particulièrement rapide est souhaitable. Dans un tel système, l'épaisseur du polymère est réglée de telle sorte que le film restant non exposé soit suffisamment épais pour protéger le substrat lors du traitement ultérieur.

D'autre part, un système de solvant qui n'affecte que les régions exposées peut éventuellement être employé lors du développement. On peut également utiliser aux fins du développement un mélange d'un solvant capable de dissoudre le polymère indépendamment de sa masse moléculaire, et d'un liquide incapable de dissoudre ce même polymère indépendamment de sa masse moléculaire, dans des proportions suffisantes pour provoquer uniquement la dissolution des parties exposées.

Quelques solvants convenables sont le méthyléthyl-cétone, les acides carboxyliques liquides, les cétones, les éthers éthylglycoliques, les hydrocarbones chlorurés, par exemple le chlorobenzène, le chloroforme, le diméthylformamide, le diméthylsulfoxyde ou des mélanges des différents produits ou des mélanges de ces derniers avec de l'eau ou des alcools ou d'autres solvants organiques ou des non solvants, par exemple l'hexane, l'éther de pétrole, les alcanes, etc. .

L'image réalisée dans la résine sensible peut faire l'objet d'une post-cuisson afin de retirer les solvants

0004555

13

du produit de développement. Normalement, les températures employées doivent être inférieures au point de
fusion ou à la température de passage du film à l'état
vitreux. En général, la température de post-cuisson est
comprise entre 130° et 160°C environ, selon le polymère
particulier qui est utilisé. Par comparaison, lorsqu'on
utilise le polyméthacrylate de méthyle ou les polyoléfinsulfones de l'art antérieur, la température ne doit pas
dépasser 135°C. L'augmentation de la thermostabilité
qui est rendue possible par la présente invention est
particulièrement utile dans les étapes métallurgiques
avec la technique dite de décollement puisque, lors de
ces traitements, le dépôt du métal s'effectue de préférence
à des températures élevées.

Ces images formées à partir des copolymères de méthacrylate de plomb présentent une plus grande sensibilité,
un meilleur contraste, une facilité de formation de
film équivalente et une meilleure stabilité en température que celles réalisées à partir du polyméthacrylate
de méthyle (PMMA).

Lors du décapage ionique ou du décapage effectué par
ions réactifs, par pulvérisation ou dans du plasma, le
bombardement de la tranche par des corps chimiques ionisés provoque une augmentation de sa température. Si
cette dernière est suffisamment élevée, la résine sensible peut se décomposer chimiquement ou commencer à
fondre et à couler. Dans un cas comme dans l'autre,
cela se traduira par une détérioration de la fidélité
de la configuration décapée. La meilleure stabilité en
température que présentent les copolymères de méthacrylate de plomb permet de retarder le début de cette
dégradation. Cela permet d'appliquer une énergie

14

supérieure au dispositif employé aux fins du décapage et de diminuer le coût du traitement.

La technique de décollement est fréquemment utilisée lorsqu'on désire obtenir des configurations présentant une résolution élevée. Il est souvent nécessaire de chauffer le substrat afin que le métal évaporé adhère mieux à celui-ci. Le permalloy utilisé aux fins de la réalisation de configurations de bulles magnétiques en est un exemple. Si la température est trop élevée, le masque en résine sensible peut couler et de ce fait empêcher le décapage latéral qui est indispensable pour obtenir un décollement satisfaisant. Etant donné que les copolymères de méthacrylate de plomb coulent à une température dépassant de 25° à 30°C environ celle du PMMA, une température de substrat plus élevée peut être employée et l'on peut obtenir une meilleure adhérence. Cela permet également de diminuer les effets du chauffage rayonnant émanant de la source d'évaporation.

Les exemples non limitatifs de composition de A à T qui sont donnés ci-après ont pour but d'illustrer la présente invention.

## EXEMPLE A

Copolymère composé de 99,72% en mole de méthacrylate de méthyle et de 0,28% en molde d'un méthacrylate de Pb.

On fait dissoudre 9,5 g de méthacrylate de méthyle et 0,5 g de méthacrylate de Pb dans 5ml d'acide acétique glacial dans un récipient supportant la pression. On ajoute ensuite 50ml environ d'azobisisobutyronitrile. Ledit récipient est ensuite bouché et chauffé à une

15

température de 78°C pendant 30mn environ.

On provoque la précipitation du polymère dans la solution en ajoutant à celle-ci du chloroforme, puis de l'alcool méthylique. On fait ensuite dissoudre le polymère précipité dans le chloroforme et on provoque sa reprécipitation dans l'alcool méthylique. Le polymère est lavé dans ce dernier et séché dans le vide à une pression d'environ 10mm de mercure à température ambiante de manière à obtenir 2,5g environ de polymère.

La spectrophotométrie par absorption atomique montre qu'il s'agit d'un polymère composé de 99,72% en mole de méthacrylate de méthyle et de 0,28% en mole de méthacrylate de Pb. Ce polymère présente un $\overline{Mw}$ d'environ $180 \times 10^3$ et un $\overline{Mn}$ d'environ $95 \times 10^3$.

EXEMPLE B

Copolymère composé de 99,7% en mole de méthacrylate de méthyle et de 0,30% en mole de méthacrylate de baryum.

On fait dissoudre 9g de méthacrylate de méthyle et 1g environ de méthacrylate de Ba dans 10ml d'acide acétique glacial. On ajoute ensuite 50mg environ d'azobisisobutyronitrile audit récipient. Ce dernier est ensuite bouché et porté à une température de 78°C environ pendant 30 minutes environ. Le polymère est précipité dans la solution en ajoutant à celle-ci du chloroforme, puis de l'alcool méthylique. On dissout ensuite le polymère précipité dans le chloroforme et on provoque sa nouvelle précipitation dans l'alcool méthylique.

On fait ensuite sécher le polymère dans le vide à une

16

pression d'environ 10mm à température ambiante pour obtenir 2g environ de polymère. La spectrophotométrie par absorption atomique de ce dernier montre qu'il s'agit d'un polymère composé d'environ 99,7% en mole de méthacrylate de méthyle et de 0,3% en mole de méthacrylate de Ba. Ce polymère présente un poids moléculaire moyen d'environ $90 \times 10^3$.

EXEMPLE C

Copolymère composé de 99,93% en mole de méthacrylate de méthyle et de 0,08% en mole de méthacrylate de Ca.

La préparation est identique à celle décrite à propos des exemples A et B ci-dessus, à l'exception du fait que l'on fait dissoudre 9g de méthacrylate de méthyle et 1g de méthacrylate de Ca dans 10ml d'acide acétique glacial. La spectrophotométrie du copolymère par absorption atomique montre qu'il s'agit d'un polymère composé de 99,92% en mole environ d'un méthacrylate de méthyle et de 0,08% en mole de méthacrylate de Ca et qu'il contient environ 0,032% de Ca. Ce polymère présente un $\overline{M\omega}$ d'environ 180K et un $\overline{Mn}$ d'environ 90K.

EXEMPLE D

Copolymère composé de 99,987% en mole de méthacrylate de méthyle et de 0,013% en mole de méthacrylate de Sr.

La préparation est identique à celle déjà décrite à propos des exemple A et B ci-dessus, à l'exception du fait que l'on fait dissoudre 8,5g de méthacrylate de méthyle et 1,5g de méthacrylate de Sr dans 10ml d'acide acétique glacial.

17

La spectrophotométrie par absorption atomique montre qu'il s'agit d'un polymère composé d'environ 99,987% en mole de méthacrylate de méthyle et 0,013% en mole de méthacrylate de Sr contenant 0,011% de Sr. Ce polymère présente un $\overline{M\omega}$ d'environ $180 \times 10^3$ et un $\overline{Mn}$ d'environ $100 \times 10^3$.

EXEMPLE E

Copolymère composé de 98,51% en mole de méthacrylate de méthyle et de 1,49% en mole de méthacrylate de Pb.

La préparation est identique à celle décrite à propos des exemples A et B ci-dessus, à l'exception du fait que l'on fait dissoudre 9g de méthacrylate de méthyle et 1g de méthacrylate de Pb dans 3ml d'acide acétique glacial.

La spectrophotométrie par absorption atomique montre qu'il s'agit d'un polymère composé d'environ 98,5% en mole de méthacrylate de méthyle et d'environ 1,5% en mole de méthacrylate de plomb, et qu'il contient 2,96% de Pb. Ce polymère présente un $\overline{M\omega}$ d'environ $200 \times 10^3$ et un $\overline{Mn}$ d'environ $100 \times 10^3$.

EXEMPLE F

Copolymère composé de 97,25% en mole de méthacrylate de méthyle et de 2,75% en mole de méthacrylate de Pb.

La préparation est identique à celle décrite à propos des exemples A et B, à l'exception du fait que l'on fait dissoudre 9,5g de méthacrylate de méthyle et 1,5g de méthacrylate de Pb dans 10ml d'acide acétique glacial.

18

Le polymère présente un $\overline{M\omega}$ d'environ $200 \times 10^3$ et un $\overline{Mn}$ d'environ $100 \times 10^3$. La spectrophotométrie par absorption atomique montre qu'il s'agit d'un polymère composé d'environ 97,25% en mole de méthacrylate de méthyle et d'environ 2,75% en mole de méthacrylate de Pb.

Les exemples de compositions G à T sont donnés dans le tableau I ci-dessous.

### TABLEAU I

#### COMPOSITIONS DES POLYMERES

| Exemple de composition | Polymère | % en poids de métal |
|---|---|---|
| G | 85/15Ba20 | 0,17 |
| H | 85/15Ba10 | 0,24 |
| I | 90/10Ba10 | 0,41 |
| J | 95/5Ba10 | 0,08 |
| K | 95/5Pb10 | 0,58 |
| L | 90/10Pb10 | 0,81 |
| M | 90/10Pb3 | 2,96 |
| N | 85/15Pb10 | 5,30 |
| O | 95/5Ca10 | 0,027 |
| P | 90/10Ca10 | 0,032 |
| Q | 85/15Ca10 | 0,027 |
| R | 95/5Sr10 | 0,019 |
| S | 90/10Sr10 | 0,003 |
| T | 85/15Sr10 | 0,011 |

19

La désignation des polymères s'est faite avec un code de la forme: a/bMEc, où:

a    est le nombre de g de méthacrylate de méthyle (X10)

b    est le nombre de g de méthacrylate métallique (X10)

ME    est le métal incorporé

c    est le nombre de ml d'acide acétique employé.

Les compositions indiquées dans ce tableau ont été préparées de la façon décrite dans les exemples A à F. Les exemples ci-dessous sont destinés à illustrer les applications à la lithographie par faisceau d'électrons.

## EXEMPLE 1

On prépare une solution d'environ 10% en poids d'un polymère constitué par un mélange de 90% en mole de méthacrylate de méthyle et de 10% en mole de méthacrylate de Pb conformément à l'exemple E et présentant un $\overline{M\omega}$ d'environ 180K, un $\overline{Mn}$ d'environ 100K et une stabilité thermique d'environ 160°C dans de l'acétate d'éther éthylglycolique. Ladite solution est déposée par centrifugation à 1000 tours/mn environ sur une couche en $SiO_2$ d'une épaisseur de 0,5 micron de manière à obtenir sur celle-ci un film d'environ 0,5 micron. Ce dernier fait ensuite l'objet d'une pré-cuisson à 160°C environ pendant 1 heure. Le film est ensuite exposé dans le vide à un faisceau électronique d'un diamètre de 0,1 micron, la dose employée étant de $3 \times 15^5 C/cm^2$ à 20kv. Le film est ensuite développé dans du méthyl-éthylecétone à 25°C pendant 2 minutes. La région exposée est retirée par le solvant, ce qui donne une image

20

positive. L'épaisseur nette du film restant dans la
région non exposée correspond à 90% environ de l'épaisseur initiale. L'échantillon est rincé dans de l'éthanol
et séché à 70°C pendant 10 minutes. La couche d'oxyde
est décapée avec de l'acide fluorhydrique tamponné à
21°C de façon à donner des images de 0,5 micron, elle
peut constituer une couche de masquage. Le film est
éliminé en le plongeant pendant 5 minutes dans de
l'étheréthyl glycolique à 70°C, cette opération étant
suivie d'un rinçage dans de l'eau et d'un séchage dans
un four. Aucun résidu ne subsiste.

## EXEMPLE 2

On fait dissoudre un polymère présentant un $\overline{M\omega}$ de
200 000 composé de 9 parts de méthacrylate de méthyle
et d'une part de méthacrylate de plomb dans de l'acétate
d'éther éthylglycolique de manière à obtenir une solution à 10% en poids. On dépose ensuite cette dernière
par centrifugation à 2000 tours/mn sur une tranche de
grenat. Un film d'une épaisseur d'environ 1,2 micron
est ainsi formé. On fait cuire la tranche à 160° pendant une heure, puis on l'expose à un faisceau électronique d'un diamètre de 0,1 micron à 20keV, la dose
employée étant de $3 \times 10^{-5} C/cm^2$. La tranche est ensuite
développée pendant 2 minutes environ dans du méthyéthylcétone à température ambiante. La configuration
ainsi exposée présente le décapage latéral indispensable aux fins d'un décollement.

La tranche est ensuite placée dans un système à vide
et portée à une température de 160°C. On la recouvre
ensuite par évaporation d'une couche de 1 micron d'un
alliage nickel-fer. On retire ensuite la tranche et on

21

la plonge dans de l'acétate d'éther éthylglycolique à 70°C pour dissoudre la résine sensible et supprimer le métal indésirable. Une configuration présentant une résolution élevée est ainsi obtenue.

EXEMPLE 3 à 12

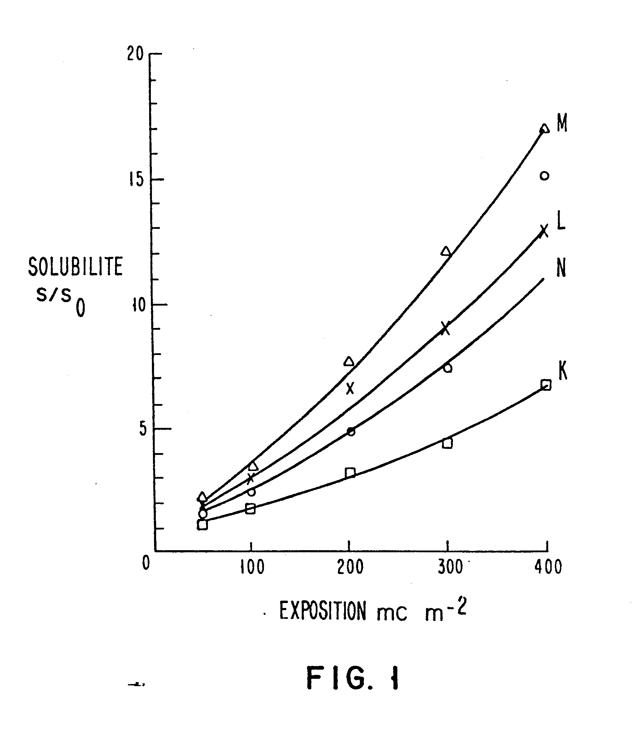

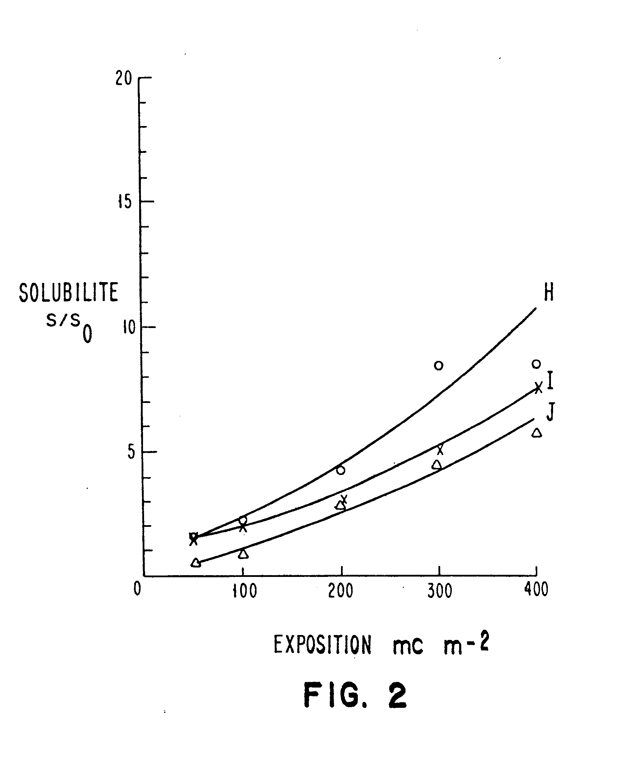

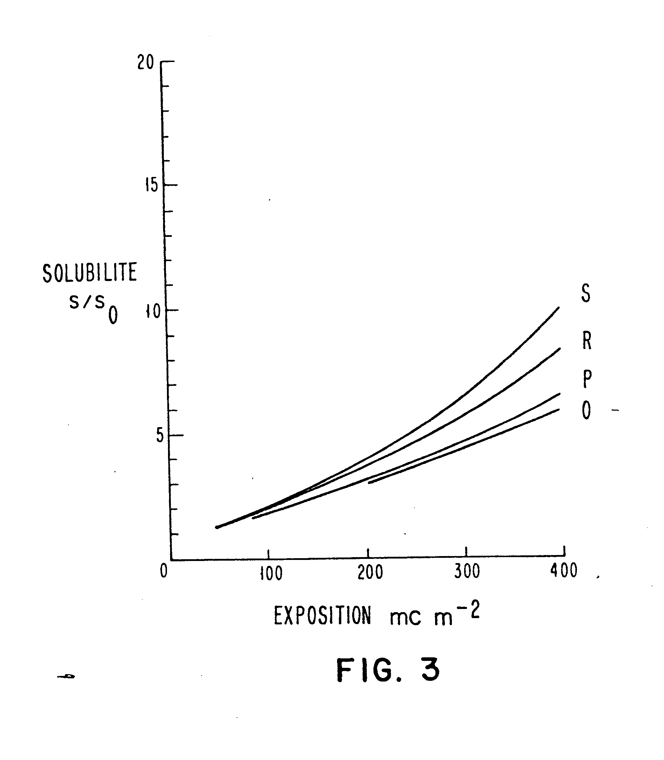

Quelques films ont été préparés à partir des compositions obtenues de la façon décrite dans les exemples A à T conformément au procédé décrit à propos de l'exemple 1. Les rapports de solubilité ont été déterminés et sont indiqués sur les figures 1 à 3, par correspondance avec les exemples de composition du tableau I. Le rapport S sur So, définit les solubilités respectives des parties exposées et non exposées.

EXEMPLE 13

Cet exemple est une explication réalisée à partir d'une composition typique de l'art antérieur.

Une solution à 10% environ en poids d'un polyméthacrylate de méthyle (PMMA) présentant un $\overline{M\omega}$ d'environ $2 \times 10^5$ et une stabilité thermique de 120°C a été préparée, puis déposée par centrifugation à 3000 tours/mn sur un substrat en oxyde thermique de silicium d'une épaisseur de 0,5 micron de manière à obtenir sur celui-ci un film d'environ 0,5 micron. Ce film a ensuite fait l'objet d'une pré-cuisson à 160°C environ pendant une heure environ, puis a été exposé dans le vide au moyen d'un faisceau électronique d'un diamètre de 0,1 micron à une dose de $10^{-4}$ coulombs/$cm^2$ à 20kv. Le film a ensuite été développé dans du méthylisobutylcétone à 20°C pendant 4 minutes. La région exposée a été retirée par le solvant, ce qui a donné une image positive.

22

L'épaisseur nette du film restant dans la région non exposée correspondait à 90% environ de l'épaisseur initiale. L'échantillon a ensuite été rincé dans de l'isopropanol et séché à 70°C pendant 10 minutes. L'oxyde d'une épaisseur de 0,5 micron a été décapé avec de l'acide fluorhydrique tamponné à 21°C pour donner des images de 0,5 micron aux fins d'une étape de masquage. On a ensuite procédé à l'élimination du film en le plongeant pendant 5 minutes dans de l'éther éthylglycolique à 70°C, puis à son rinçage dans de l'éthanol et à son séchage dans un four.

EXEMPLE 14

Cet exemple correspond à une autre composition typique de l'art antérieur.

On fait dissoudre du polyméthacrylate de méthyl présentant un $\overline{Mw}$ de 200 000 dans de l'acétate d'éther éthylglycolique de manière à obtenir une solution à 10% en poids de polymère que l'on dépose ensuite par centrifugation à 3000 tours/mn sur une tranche de grenat de manière à obtenir sur celle-ci un film d'une épaisseur d'environ 1,2 microns. On fait ensuite cuire la tranche à 160°C pendant 1 heure.

On expose la configuration dans la résine sensible au moyen d'un faisceau électronique d'un diamètre de 0,1 micron à 20 kV. Afin d'obtenir le décapage latéral qui est indispensable aux fins du décollement, il est nécessaire d'exposer la configuration en employant une dose de $10 \times 10^{-5} C/cm^2$.

Après exposition, la tranche est développée pendant 3 minutes environ à température ambiante dans du méthylisobutylcétone, puis placée dans le système à vide dans lequel on provoquera l'évaporation de l'alliage nickel-fer. Etant donné que la résine sensible va commencer à couler, la température maximum admissible du substrat pendant l'évaporation est de 120°C. Une couche de 1 micron de l'alliage de nickel-fer est déposée par évaporation.

La tranche est ensuite retirée et plongée dans de l'acétate d'éther éthylglycolique à 70°C de manière à dissoudre la résine et à provoquer le décollement du métal indésirable.

On obtient ainsi une configuration de nickel-fer présentant une résolution élevée, mais en raison des températures inférieures qui sont utilisées pour le substrat pendant l'évaporation, l'adhérence de la couche métallique n'est pas aussi bonne, qu'elle l'était avec les compositions de résine de la présente invention.

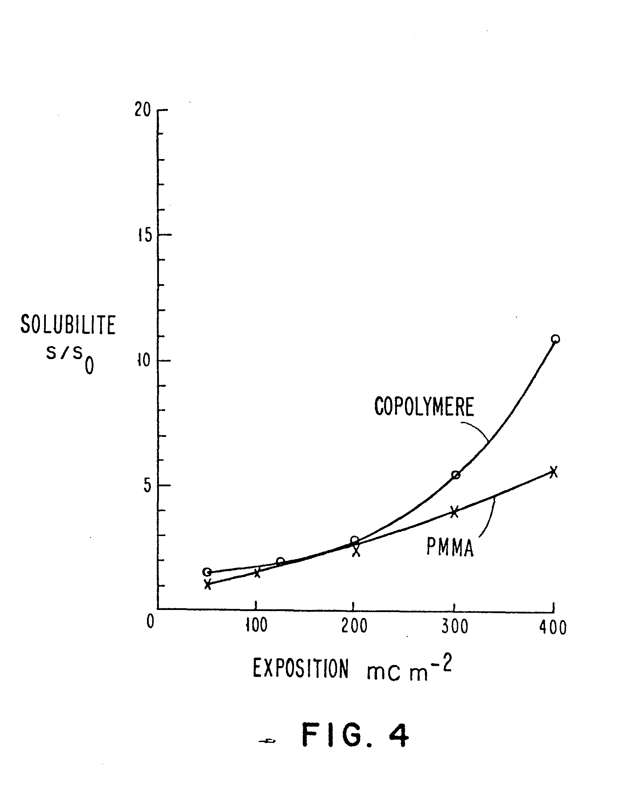

Ainsi qu'on peut le constater en comparant les exemples 1 à 12 avec les exemples 13 et 14, la sensibilité du polyméthacrylate de méthyle peut être multipliée par trois lorsque ce matériau est copolymérisé avec un sel de l'acide méthacrylique et d'un métal. Dans ces conditions les rapports de solubilité de diverses compositions sont représentés sur les figures 1 à 3. Egalement une comparaison entre les rapports de solubilité d'une composition de résine copolymère conforme à l'invention et une composition de type PMMA est donnée sur la figure 4.

En d'autres termes pour exposer une configuration de

24

PPMA avec un rapport de solubilité donné, il est nécessaire d'employer une radiation trois fois plus importante que dans le cas des copolymères de méthacrylate de plomb de la présente invention.

Sur la figure 4 on voit que la plage utile d'expositions pour un des meilleurs copolymères de méthacrylate de plomb est comprise entre $0,5 \times 10^{-5}$ et $3 \times 10^{-5}$ coulombs/cm$^2$. Dans cette plage, il présente un rapport de solubilité (S/So) compris entre 2 et 10, alors que celui du PMMA est compris entre 1 et 4 approximativement. Le contraste des copolymères de méthacrylate de plomb est donc approximativement le double de celui du PMMA. Pour obtenir les mêmes rapports de solubilité, il faut augmenter l'exposition du PMMA et la faire passer à une valeur comprise entre $2 \times 10^{-5}$ et $10 \times 10^{-5}$ C/cm$^2$. En conclusion, la sensibilité du PMMA est généralement trois fois moindre que celle des copolymères de méthacrylate de plomb.

Il est important de comprendre que la sensibilité de la résine sensible doit être aussi élevée que possible puisque cela a pour effet d'augmenter la cadence à laquelle les tranches peuvent être exposées dans un dispositif donné et par conséquent de diminuer le coût du produit finalement obtenu.

C'est pourquoi les compositions de résine conformes à l'invention trouvent tout naturellement une application immédiate dans les étapes de lithographie par faisceau d'électrons, dans la fabrication des circuits intégrés monolithiques à semi-conducteurs.

Bien que l'on ait décrit dans ce qui précède et repré-

25

senté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

0004555

1

REVENDICATIONS

1. Résine sensible aux électrons constituée par un polymère non réticulé, caractérisée en ce qu'elle comporte:

a) des unités polymérisées de méthacrylate d'alkyle dans lesquelles le groupe alkyle contient de 1 à 4 atomes de carbone, et

b) des unités polymérisées du sel de l'acide méthacrylique, et d'un métal, ce dernier étant choisi dans le groupe composé du baryum, du calcium, du plomb et du strontium,

la quantité desdites unités de type a) est comprise entre 50% environ et 99,99% environ en mole, et la quantité desdites unités de type b) est comprise entre 50% environ et 0,01% environ en mole, sur la base du nombre total de moles de type a) et de type b) tandis que le métal présent constitue de 0,001% à 10% environ en poids du polymère.

2. Résine selon la revendication 1, caractérisée en ce que le métal choisi est le baryum et qu'il

2

constitue environ 0,05% à environ 0,45% en poids du polymère.

3. Résine selon la revendication 1, caractérisée en ce que le métal choisi est le calcium et qu'il constitue environ 0,02% à environ 0,035% en poids du polymère.

4. Résine selon la revendication 1, caractérisée en ce que le métal choisi est le plomb et qu'il constitue environ 1% à environ 4% en poids du polymère.

5. Résine selon la revendication 1, caractérisée en ce que le métal choisi est le strontium et qu'il constitue environ 0,003% à environ 0,02% en poids du polymère.

6. Application à la lithographie par faisceau d'électrons, d'une résine telle que définie par l'une quelconque des revendications ci-dessus pour former une image, caractérisée en ce qu'elle comporte les étapes suivantes:

1. formation d'un film de résine sur un substrat,

2. exposition du film à un faisceau d'électrons selon une configuration désirée pour transformer le polymère en copolymère, et

3. élimination des portions exposées du film pour ne laisser subsister que l'image désirée.

FIG. 1

FIG. 2

FIG. 3

FIG. 4